# EUROPÄISCHE PATENTSCHRIFT

(11) **EP 1 943 732 B1**
(45) Veröffentlichungstag und Bekanntmachung des Hinweises auf die Patenterteilung: **13.06.2012**
(21) Anmeldenummer: 06807658.7
(22) Anmeldetag: 30.10.2006
(51) Int. Cl.: H03K 17/082

(54) **ELEKTRONISCHE SCHALTUNGSANORDNUNG MIT EINEM ODER MEHREREN HALBLEITER-HAUPTRELAIS UND DEREN VERWENDUNG**
ELECTRONIC CIRCUIT COMPRISING AT LEAST ONE SEMICONDUCTOR MAIN RELAY AND USE OF THE SAME
CIRCUIT ELECTRONIQUE COMPORTANT UN OU PLUSIEURS RELAIS PRINCIPAUX A SEMICONDUCTEURS ET UTILISATION

(30) Priorität: 31.10.2005 DE 102005052405; 30.10.2006 DE 102006051722
(43) Veröffentlichungstag der Anmeldung: 16.07.2008
(73) Patentinhaber: Continental Teves AG & Co. oHG, 60488 Frankfurt (DE)
(72) Erfinder: FEY, Wolfgang, 65527 Niedernhausen (DE); HEINZ, Micha, 64293 Darmstadt (DE); DIETZ, Timo, 65239 Hochheim (DE); JOECKEL, Wolfgang, 63179 Obertshausen (DE); LUCIUS, Lars, 61352 Bad Homburg (DE)
(86) Internationale Anmeldenummer: PCT/EP2006/067931
(87) Internationale Veröffentlichungsnummer: WO 2007/051777

(56) Entgegenhaltungen:
- US-A1- 5 828 245
- US-A1- 5 939 908

## Beschreibung

Die Erfindung betrifft eine elektronische Schaltungsanordnung gemäß Anspruch 1 sowie deren Verwendung in einem Kraftfahrzeugbremssystem, insbesondere einem Fahrdynamikregelungssystem, oder einem System zur Fahrwerksregelung oder in einer Ansteuerelektronik für Fahrzeugsicherheitssysteme.

Moderne elektronische Kraftfahrzeugbremssysteme umfassen neben der Blockiererhinderungsfunktion ABS häufig je nach Ausstattungsgrad und sensorischer Ausstattung noch weitere Sicherheits- oder auch Komfort-Funktionen, wie zum Beispiel eine elektronische Bremskraftverteilung (EBV), eine Fahrdynamikregelungsfunktion (ESP) oder auch ein Abstandsregelungssystem (ACC). Diese Funktionen werden zentral in einem programmgesteuerten Mikroprozessorsystem ausgeführt, dass Bestandteil einer elektronischen Schaltungsanordnung ist, die innerhalb des Gehäuses eines elektronischen Regelgehäuses angeordnet ist. Das elektronische Reglergehäuse ist in der Regel unmittelbar mit einem Hydraulikblock verbunden, welcher unter anderem elektrohydraulische Hydraulikventile enthält, mit denen sich der Bremsdruck in Radbremsenkreisen des Kraftfahrzeugs einregeln lässt. Zur elektrischen Ansteuerung der Hydraulikventile und den übrigen, mit dem Regler verbundene zusätzliche Verbraucher, die von dem Mikroprozessorsystem angesteuert werden. Typische zusätzliche Verbraucher sind beispielsweise ein Hydraulikpumpenmotor und eine Ansteuerung für einen Bremskraftverstärker (Booster).

Die elektrischen Ansteuerstufen bzw. Treiber zur Ansteuerung der oben erwähnten Lasten sind in an sich bekannten Bremssystemen über ein gemeinsames, sogenanntes Halbleiter-Hauptrelais (Main Driver) mit der Spannungsversorgung verbunden, welches zum Beispiel durch einen Leistungshalbleiter (z.B. Power-FET) realisiert ist. Durch das Halbleiter-Hauptrelais können die Verbraucher in der Elektronikeinheit mit einem einzigen Schalter, zum Beispiel bei Auftreten eines Fehlers, ausgeschaltet werden. Das Hauptrelais erfüllt somit eine wichtige Sicherheitsfunktion in dem hier beschriebenen an sich bekannten Kraftfahrzeugbremsensteuergerät.

Es besteht nun das Problem, dass während der Auslieferungsphase eines Kraftfahrzeugs an einen Zwischenhändler oder Endkunden der Fall eintreten kann, dass das vorstehend erwähnte, in das Fahrzeug eingebaute elektronische Steuergerät nicht zu jeder Zeit über die übliche Stromversorgung des Kraftfahrzeugs, welche beispielsweise durch eine geladenen Bordbatterie und/oder einen realisiert ist, versorgt wird. Während des Betriebs eines Kraftfahrzeug treten hin und wieder Situationen auf, in denen die Stromversorgung des Steuergeräts elektrisch mit externer Energiestationen, wie z.B. durch Fremdstarthilfe mit primitiven Stromgeneratoren (sogenannte "Jump Start"-Einrichtungen) oder dergleichen verbunden werden und ein Startvorgang durchgeführt wird. Einige Fahrzeughersteller schreiben sogar vor, dass die Steuergeräte robust gegenüber einem kurzzeitigen Betrieb mit derartigen einfachen Generatoren sind. Zum Schutz der Elektronik sind die Steuergeräte, von denen die Erfindung ausgeht, so ausgelegt, dass diese bei einer nicht innerhalb der Spezifikation liegenden Versorgungsspannung das Hauptrelais abschaltet. Darüber hinaus wird die vorhandene Sicherheitselektronik (watch dog) in einen blockierten Zustand versetzt, der nur durch einen vollständigen Reset aufgehoben werden kann. Hierdurch ist es nicht mehr möglich, dass das Steuergerät seine Regelungsfunktionen (z.B. ABS oder ESP) durchführt. Ein solcher blockierter Zustand kann vor allem dann auftreten, wenn Überspannungen der Stromversorgung (z.B. Abklemmen der Batterie) auftreten, welche als "Load Dump Transienten" bezeichnet werden. Eine Schaltungsanordnung gemäß Oberbegriff des unabhängigen Anspruchs 1 ist aus dem Dokument US-A-5 828 245 bekannt. Aufgabe der vorliegenden Erfindung ist es nun, eine Schaltungsanordnung mit Treiberstufen für Lasten anzugeben, welche auf die obigen übermäßigen Schwankungen der Stromversorgung nicht mit einer vollständigen Unterbrechung der Stromversorgung reagiert.

Diese Aufgabe wird erfindungsgemäß gelöst durch die Schaltungsanordnung gemäß Anspruch 1.

Die erfindungsgemäße Schaltungsanordnung stellt eine Verbesserung einer an sich bekannten Ansteuerschaltung zur gemeinsamen Energieansteuerung von Halbleiter-Treiberstufen dar. Die Treiberstufen sind vorzugsweise in einem gemeinsamen Leistungsbauelement zusammengefasst und umfassen zum Beispiel Magnetventiltreiber und Pumpenmotortreiber. Das Leistungsbauelement kann als eigenständiger elektronischer Baustein getrennt von dem Baustein mit dem Mikroprozessorssystem ausgeführt sein. Es ist aber ebenfalls möglich und alternativ bevorzugt, dass das Leistungsbauelement gemeinsam mit dem Mikroprozessorsystem in einem elektronischen Baustein integriert ist.

Durch die erfindungsgemäße Schaltungsanordnung wird unter anderem sichergestellt, dass eine Ventilregelung bzw. Bremsverstärkerfunktion auch nach oder während des Vorliegens von Versorgungsspannungsschwankungen, insbesondere Überspannungen der Spannungsversorgung, zu der das Hauptrelais eine elektrische Verbindung herstellt, gewährleistet ist.

Für heutige Anwendungen kann es sinnvoll sein, die Schaltungsanordnung so auszulegen, dass diese bei einer Versorgungsspannungsschwankungssituation nicht abschaltet. Um dieser Anforderung nachzukommen, ist vorgesehen, eine dynamisch wirkende Spannungsbegrenzung für die Treiberstufen, wie insbesondere Ventil- bzw. Booster-Treiber, vorzusehen. Diese ist vorzugsweise so ausgelegt, dass die übrigen bestehenden Funktionalitäten des elektronischen Steuergeräts nicht beeinflusst werden.

Dies wird dadurch erreicht, dass das oder die bereits eingesetzte/n Halbleiter-Hauptrelais, welches/welche bevorzugt durch einen High-Side-Treiber, insbesondere ausgeführt als MOSFET-Transistorstruktur, nicht nur im Schaltbetrieb genutzt wird/werden, sondern in einen Spannungsregler eingebunden ist/sind. Der Betriebszustand der Ansteuerschaltung für das oder die Halbleiter-Hauptrelais wird gemäß der Erfindung in ausgewählten Situationen umgeschaltet. Eine ausgewählte Situation besteht vorzugsweise dann, wenn die Versorgungsspannung der Schaltungsanordnung einen bestimmten festgelegten Wert, insbesondere für eine bestimmte vorgegebene Zeitspanne überschreitet. Im geregelten Betrieb wird das bzw. werden die Halbleiter-Hauptrelais bevorzugt so betrieben, dass ab einem bestimmten Schwellwert die Spannung an der durch das Halbleiter-Hauptrelais "geschalteten" Last beziehungsweise an den Lasttreibern (z.B. Ventil- und Booster-Treiber begrenzt wird (schwellwertabhängiger Spannungsregler). Damit keine thermische Zerstörung des Halbleiter-Hauptrelais eintreten kann, wird der Linearregelbetrieb vorzugsweise zeitlich begrenzt. Dies geschieht insbesondere dadurch, dass eine Überwachung der Umschaltphase durch einen zusätzlichen Timer, welcher zum Beispiel durch Software realisiert ist, vorgenommen wird.

Weitere bevorzugte Ausführungsformen ergeben sich aus den abhängigen Ansprüchen und der nachfolgenden Beschreibung der Figuren.

Nachfolgend wird die Erfindung an Hand von Figuren noch näher beschrieben.

Es zeigen
- Fig. 1: ein Blockschaltbild für eine beispielgemäße, nicht beanspruchte Schaltungsanordnung und
- Fig. 2: ein Beispiel für eine konkretisierte Schaltungsanordnung gemäß der Erfindung, für die Anwendung in einem elektronischen Steuergerät eines Kraftfahrzeugbremssystems.

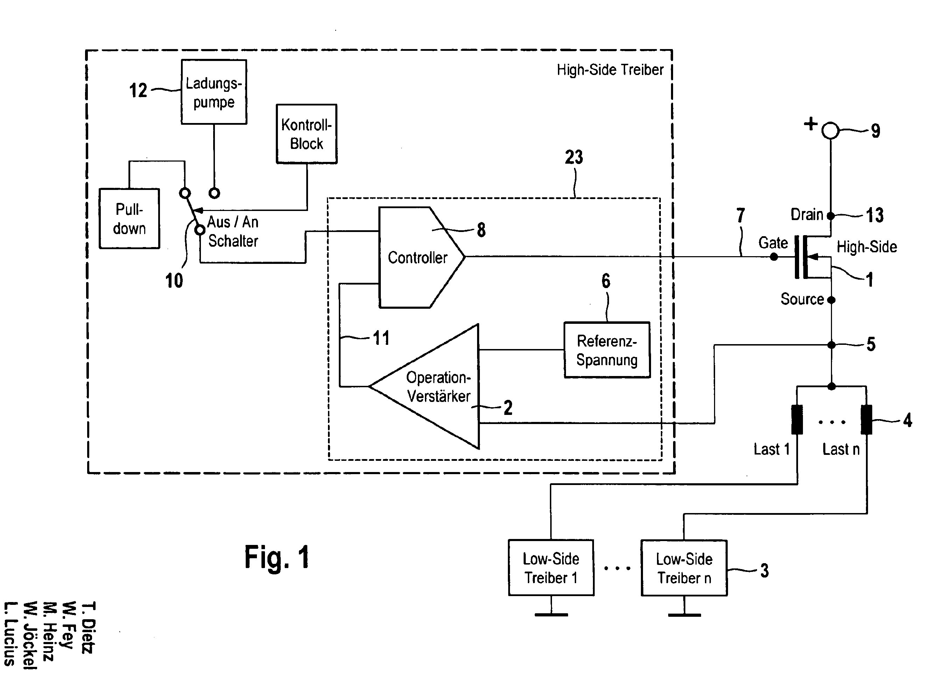

In Fig. 1 ist Halbleiter-Hauptrelais 1 ein N-Kanal MOSFET Transistor, welcher zwischen Versorgungsspannung 9 und den durch die Low-Side-Treiber 3 getriebenen Lasten 4, hier Ventile und Boosteransteuerung, geschaltet ist. Halbleiter-Hauptrelais 1 wird von einer weiter unten näher erläuterten Ansteuerschaltung 8 angesteuert, die zur Einstellung des Widerstands von Halbleiterrelais 1 geeignet ist. Schalter 10 ist mit dem Eingang von Ansteuerschaltung 8 verbunden und dessen Schaltzustand bewirkt ein weitgehend vollständiges Öffnen und Schließen des Halbleiter-Hauptrelais 1, wie es auch bei herkömmlichen Halbleiterrelais der Fall ist. Die vorliegende Schaltung ist durch eine Regelschleife bestehend aus Operationsverstärker 2, Referenzspannungsquelle 6 und Potentialabgriff 5 so erweitert, dass damit ein Regelbetrieb des Widerstands des High-Side MOSFETs 1 durchführbar ist. Die Bauelemente Ansteuerschaltung 8, Operationsverstärker 2 und Referenzspannungsquelle 6 können zweckmäßigerweise in einem gemeinsamen Baustein 23 integriert sein.

Im folgenden wird die Funktionsweise von Ansteuerschaltung 8 näher beschrieben. Im Normalbetrieb, wenn keine Überspannung oder ähnliches vorhanden ist, wird N-Kanal MOSFET 1 mittels Ansteuerschaltung 8 im linearen Bereich wie ein Schalter betrieben. Für die Spannungsregelung während einer Überspannung auf der Versorgungsleitung wird der vom High-Side-Treiber angesteuerte N-Kanal MOSFET aus dem Linearbereich in den Sättigungsbereich gebracht. Über eine Leitung wird das Potential an Source-Pin 5 des Halbleiterhauptrelais 1 überwacht. Wenn die Spannung oberhalb eines vorgegebenen Grenzwerts liegt, wird Überspannung angenommen und eine Änderung des Betriebsmodes des MOSFETs 1 vom Schaltbetrieb in den Linearbetrieb vorgenommen. Solange die Spannung an Source-Pin 5 unterhalb der Referenzspannung liegt, bewirkt Operationsverstärker 2 über Leitung 11 ein Massepotential auf Steuerleitung 11, welches eingangsseitig Ansteuerschaltung 8 zugeführt ist. Das Signal an Leitung 11 bewirkt, dass Ansteuerschaltung 8 hochohmig ist und der Reglerschaltkreis nicht aktiv ist. Überschreitet die Spannung an Source-Pin 5 die Referenz-Spannung, so wird über Leitung 11 eine Spannung eingestellt, die den Regelbetrieb aktiviert. Durch die Spannung wird ein Transistor in Ansteuerschaltung 8 geöffnet und somit ein Pfad zum Entladen des Gates gebildet. Dadurch gerät der High-Side-MOSFET in den Sättigungsbetrieb und verringert somit die Spannung am Source-Pin bis sie dem Überspannungs-Detektierungs-Schwellwert gleich ist. Ein Spannungsabfall am Source, z.B. hervorgerufen durch einen Lastwechsel, wird durch das Ansteuern des Regeltransistors so geregelt, dass letztendlich das Source-Potential dem Detektierungs-Schwellwert wieder entspricht. Durch den auf diese Weise betriebenen MOSFET 1 kann der Betrag an Leistung, welcher auf Grund der Überspannung dem Steuergerät zugeführt wird, durch MOSFET 1 in Wärme umgewandelt werden.

Wenn keine Überspannung an Klemme 9 mehr anliegt, sinkt das Potential an Source 5 des Transistors 1 ab und fällt unter den Detektierungs-Schwellwert von Operationsverstärker 2. Die Schaltung wird somit aus dem Regelbetrieb gebracht und die Spannung der Ladungspumpe 12 unverändert an Gate 7 von High-Side-MOSFET 1 durchgeschaltet.

Die obige Schaltung wird zusätzlich durch ein Zeitmessglied erweitert, dass sich in der Software der nicht dargestellten Reglerelektronik befindet, mit dem die Dauer der Überspannung bestimmt werden kann. Überschreitet diese eine vorgegebene Zeitspanne von z.B. 500 ms, wird von der Software eine zusätzliche, unabhängige Schutzschaltung aktiviert, welche das elektronische Steuergerät vollständig abschaltet und nur durch Betätigen der Fahrzeugzündung zurückgesetzt werden kann.

Es ist vorzugsweise zusätzlich vorgesehen, eine Einrichtung zu implementieren, die eine Abschaltung der oben beschriebenen Spannungsregelungsfunktion ermöglicht.

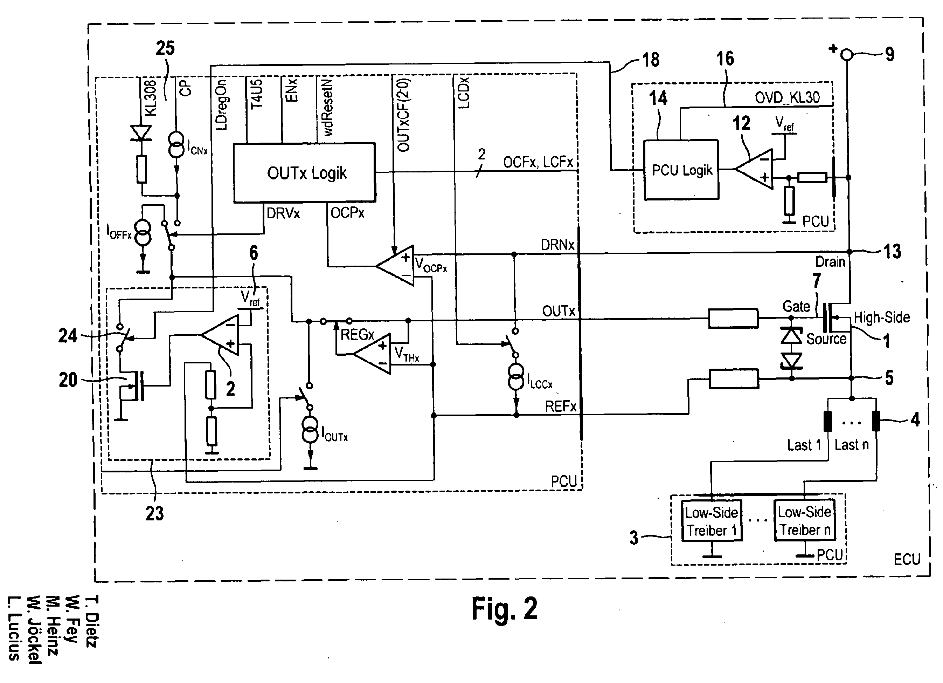

Fig. 2 zeigt ein erfindungsgemäßes, grundsätzlich entsprechend der Schaltung in Fig. 1 wirkendes Schaltungsbeispiel, das darüber hinaus weitere Schaltungselemente enthält, die für die praktische Realisierung von Bedeutung sind. Die hier beschriebene erfindungsgemäße Schaltungsanordnung umfasst zusätzlich einen weiteren Ü-berspannungs-Erkennungs-Komparator 12, welcher mit Drain-Klemme 13 von Halbleiter-Relais 1 verbunden ist. Überschreitet das Potential an Klemme 13 ein vorgegebenes Potential, so wird ein Signal an Logik 14 weitergeleitet.

Sehr kurze Überspannungsimpulse (Spikes) lösen in der Schaltung von Fig. 2 keine Umschaltung in den Regelungsbetrieb aus. Dies wird durch eine Verzögerung in Auswertelogik 14 erreicht, wobei das Ausgangssignal von Komparator 12, welcher mit Knoten 13 verbunden ist, erst nach Ablauf einer entsprechenden Zeit in ein Regelungsbetrieb-Aktivierungssignal 18 umgesetzt wird. Logik 14 enthält hierzu einen Timer, welcher das Signal erst nach Ablauf einer bestimmten Verzögerungszeit von etwa 200µs bereitstellt, um den Regelungsbetrieb über Leitung 18 zu aktivieren und ein Flag zu generieren, das auf Leitung 16 über aktive Spannungsregelung signalisiert. Außerdem dient das generierte Flag der Software als Startsignal für einen Timer, um, falls die vorgegebene Zeitspanne von etwa 500 ms überschritten wird, das Steuergerät endgültig abzuschalten.

Zeitgleich mit der Spannungsregelungs-Aktivierung wird eine vorübergehende Abschaltung des Überstrom-Erkennungs-Schutzes und der Leckstrom-Erkennungs-Stromquelle durchgeführt. Nach Ablauf der Überspannung sind diese Funktionen wieder verfügbar.

Über ein Steuerbit in Logik 14 kann die gesamte Regelschleife sowie die Flag- einschließlich der Steuersignal-Generierung abgeschaltet werden. In diesem Fall befindet sich die Schaltung in einem Betriebszustand, bei dem die erfindungsgemäße Spannungsregelung abgeschaltet ist. Eine Aktivierung/Deaktivierung der Spannungsregelung an Source 5 geschieht durch die Auswahl der beiden Zustände der Auswertungslogik 14. Je nach gewähltem Zustand reagiert die Schaltung unterschiedlich im Falle einer Überspannung an Klemme 9. Die Grundeinstellung bewirkt bei Überspannung eine Systemabschaltung, wonach nur durch Fahrzeugzündung die Reaktivierung wieder statt finden kann. Die zweite Einstellungsmöglichkeit aktiviert während einer Überspannung die Spannungsregelung von MOSFET 1 durch Schließen von Schalter 24.

Im erfindungsgemäßen Schaltungsbeispiel gemäß Fig. 2 übernimmt ein Regeltransistor 20 und ein Aktivierungsschalter 24 entsprechend Ansteuerschaltung 8 die Spannungsregelung am Gate des High-Side MOSFETs 1. Im Fall der Regelung senkt der Regeltransistor die Spannung von Ladungspumpe 25 so ab, dass MOSFET 1 in den Sättigungsbetrieb kommt. Im Normalbetrieb ist Transistor 1 vollständig durchgesteuert.

## Patentansprüche

1. Elektronische Schaltungsanordnung (5) mit einem oder mehreren Halbleiter-Hauptrelais (1), welches/welche durch einen Leistungs-Feldeffekttransistor realisiert ist/sind und mit mindestens einer Halbleiter-Treiberstufe (3) zur Ansteuerung von Lasten (4) verbunden ist, wobei das Halbleiter-Hauptrelais (1) die Lasten (4) und die Treiberstufe (3) mit einer Spannungsversorgung abschaltbar verbindet, **dadurch gekennzeichnet,**
**dass** das oder die Halbleiter-Hauptrelais als Halbleiterschalter betrieben wird/werden, bis ein Überspannungs-Erkennungs-Komparator (12), welcher mit der der Versorgungsspannung zugewandten Klemme (13) des oder der Halbleiter-Hauptrelais (1) verbunden ist, erkennt, dass die Versorgungsspannung der Schaltungsanordnung einen bestimmten festgelegten Wert überschreitet,
und **dass** in diesem Fall ein Signal an eine Auswertelogik (14) weitergeleitet wird, die durch Schließen eines Aktivierungsschalters (24) das Gate (7) des oder der Halbleiter-Hauptrelais (1) mit einem Regeltransistor (20) verbindet, um eine Spannungsregelung zu aktivieren.

2. Schaltungsanordnung nach Anspruch 1,
**dadurch gekennzeichnet,**
**dass** die Auswertelogik (14) den Aktivierungssschalter (24) nur dann schließt,
wenn die Versorgungsspannung der Schaltungsanordnung einen bestimmten festgelegten Wert für eine bestimmte vorgegebene Zeitspanne überschreitet.

3. Schaltungsanordnung nach Anspruch 1 oder 2,
**dadurch gekennzeichnet,**
**dass** mit der der Last (4) zugeordneten Klemme (5) des Hableiter-Hauptrelais (1) ein Potentialmonitor (2, 6) verbunden ist.

4. Schaltungsanordnung nach mindestens einem der Ansprüche 1 bis 3,
**dadurch gekennzeichnet,**
**dass** das Gate (7) dies Halbleiter-Hauptrelais (1) durch den Regeltransistor (20) angesteuert wird, welcher zur Einstellung des Widerstands des Halbleiter-Hauptrelais (1) geeignet ist.

5. Schaltungsanordnung nach mindestens einem der Ansprüche 1 bis 4,
**dadurch gekennzeichnet,**
**dass** der Ausgang des Potentialmonitors (2, 6) mit dem Gate des Refeltransistors (20) zu einer Regelschleife verbunden ist.

6. Schaltungsanordnung nach mindestens einem der Ansprüche 1 bis 5,
**dadurch gekennzeichnet,**
**dass** der Potentialmonitor einen Operationsverstärker (2) umfasst, der das Potential der Lastklemme (5) des Halbleiter-Hauptrelais mit einem Referenzpotential (6) vergleicht.

7. Verwendung der Schaltungsanordnung gemäß mindestens einem der Ansprüche 1 bis 6 in einem Kraftfahrzeugbremssystem oder einem System zur Fahrwerksregelung oder in einer Ansteuerelektronik für Fahrzeugsicherheitssysteme.

## Claims

1. Electronic circuit arrangement (5) comprising one or more semiconductor main relays (1) realized by a power field-effect transistor and connected to at least one semiconductor driver stage (3) for driving loads (4), the semiconductor main relay (1) connecting the loads (4) and the driver stage (3) to a voltage supply in a manner that can be turned off, **characterized in that** the semiconductor main relay or relays is/are operated as semiconductor switch(es) until an overvoltage recognition comparator (12), which is connected to that terminal (13) of the semiconductor main relay(s) (1) which faces the supply voltage, recognizes that the supply voltage of the circuit arrangement exceeds a specific defined value,
and **in that**, in this case, a signal is forwarded to an evaluation logic unit (14), which, by closing an activation switch (24), connects the gate (7) of the semiconductor main relay(s) (1) to a control transistor (20) in order to activate a voltage control.

2. Circuit arrangement according to Claim 1, **characterized**
**in that** the evaluation logic unit (14) closes the activation switch (24) only when the supply voltage of the circuit arrangement exceeds a specific defined value for a specific predetermined time period.

3. Circuit arrangement according to Claim 1 or 2, **characterized**
**in that** a potential monitor (2,6) is connected to that terminal (5) of the semiconductor main relay (1) which is assigned to the load (4).

4. Circuit arrangement according to at least one of Claims 1 to 3,
**characterized**
**in that** the gate (7) of the semiconductor main relay (1) is driven by the control transistor (20), which is suitable for setting the resistance of the semiconductor main relay (1).

5. Circuit arrangement according to at least one of Claims 1 to 4,
**characterized**
**in that** the output of the potential monitor (2,6) is connected to the gate of the control transistor (20) to form a control loop.

6. Circuit arrangement according to at least one of Claims 1 to 5,
**characterized**
**in that** the potential monitor comprises an operational amplifier (2) which compares the potential of the load terminal (5) of the semiconductor main relay with a reference potential (6).

7. Use of the circuit arrangement according to at least one of Claims 1 to 6 in a motor vehicle brake system or a system for chassis control or in a driving electronic unit for vehicle safety systems.

## Revendications

1. Dispositif de circuit électronique (5) comprenant un ou plusieurs relais principaux à semiconducteurs principaux (1) qui est/sont réalisé(s) au moyen d'un transistor à effet de champ de puissance, et connecté à au moins un étage d'attaque à semi-conducteur (3) pour commander des charges (4), dans lequel le relais principal à semi-conducteur (1) connecte les charges (4) et l'étage d'attaque (3) à une alimentation en tension pouvant être interrompue, **caractérisé en ce que**
le ou les relais à semi-conducteur est/sont attaqué(s) en tant que commutateurs à semi-conducteur jusqu'à ce qu'un comparateur de détection de surtension (12), qui est connecté à la borne (13) opposée à la tension d'alimentation du ou des relais à semi-conducteur (1), détecte que la tension d'alimentation du dispositif de circuit a dépassé une certaine valeur fixe, et **en ce que**, dans ce cas, un signal est transmis à une logique d'évaluation (14) qui connecte la grille (7) du ou des relais à semi-conducteur (1) à un transistor de commande (20) par fermeture d'un commutateur d'activation (24) afin d'activer un régulateur de tension.

2. Dispositif de circuit selon la revendication 1, **caractérisé en ce que** la logique d'évaluation (14) ne ferme le commutateur d'activation (24) que lorsque la tension d'alimentation du dispositif de circuit dépasse une certaine valeur fixe pendant une certaine période de temps prédéterminée.

3. Dispositif de circuit selon la revendication 1 ou 2, **caractérisé en ce que** qu'un moniteur de potentiel (2, 6) est connecté à la borne (5) du relais principal à semi-conducteur (1) qui est associée à la charge (4).

4. Dispositif de circuit selon au moins l'une des revendications 1 à 3, **caractérisé en ce que** la grille (7) du relais principal à semi-conducteur (1) est commandée par le transistor de commande (20) qui est conçu pour ajuster la résistance du relais principal à semi-conducteur (1).

5. Dispositif de circuit selon au moins l'une des revendications 1 à 4, **caractérisé en ce que** la sortie du moniteur de potentiel (2, 6) est connectée à la grille du transistor de commande (20) pour former une boucle de commande.

6. Dispositif à circuit selon au moins l'une des revendications 1 à 5, **caractérisé en ce que** le moniteur de potentiel comprend un amplificateur opérationnel (2) qui compare le potentiel de la borne de charge (5) du relais principal à semi-conducteur à un potentiel de référence (6).

7. Utilisation du dispositif de circuit selon au moins l'une des revendications 1 à 6 dans un système de freinage d'automobile ou dans un système de commande de suspension ou dans une électronique de commande destinée à des systèmes de sécurité de véhicules.
